# EUROPEAN PATENT APPLICATION

(11) **EP 4 687 395 A1**
(43) Date of publication of application: **04.02.2026**
(21) Application number: 25187057.2
(22) Date of filing: 02.07.2025
(51) Int. Cl.: H10D 30/01, H10D 30/65, H10D 62/13, H10D 64/27

(54) **POWER SEMICONDUCTOR DEVICES**

(30) Priority: 01.08.2024 KR 20240102657
(71) Applicant: Samsung Electronics Co., Ltd., Suwon-si, Gyeonggi-do 16677 (KR)
(72) Inventor: KIM, Taehun, 16677 Suwon-si (KR); KO, Mingu, 16677 Suwon-si (KR); PARK, Younghwan, 16677 Suwon-si (KR); PARK, Jeonghwan, 16677 Suwon-si (KR); OH, Sewoong, 16677 Suwon-si (KR)
(74) Representative: Marks & Clerk LLP

(57) **Abstract**

A power semiconductor device according to example embodiments of the present disclosure may include: a substrate including SiC of a first conductivity type; a drift layer of the first conductivity type on the substrate; a well region of a second conductivity type on the drift layer; a drain region of the first conductivity type spaced apart inwardly from an edge of the well region by a first length and disposed in the well region; a JFET region of the first conductivity type on the drift layer outside of the well region; a gate electrode extending along an upper surface of the well region and having a ring shape, the gate electrode being disposed on the upper surface of the well region; a source electrode connected to the JFET region; and a drain electrode connected to the drain region.

## Description

### BACKGROUND

The present disclosure relates to power semiconductor devices.

Power semiconductor devices are semiconductor devices that can operate in high-voltage and high-current environments and that can be used in fields requiring high-power switching, such as for power conversion, power converters, and inverters. Power semiconductor devices are fundamentally required to be able to withstand high-voltages.

### SUMMARY

Some aspects of the present disclosure are to provide a power semiconductor device having improved electrical characteristics.

According to example embodiments, a power semiconductor device may include: a substrate including silicon carbide (SiC) of a first conductivity type; a drift layer of the first conductivity type on the substrate; a well region of a second conductivity type on the drift layer; a drain region of the first conductivity type spaced apart inwardly from an entire edge of the well region by a first length and disposed in the well region; a Junction Field-Effect Transistor (JFET) region of the first conductivity type on the drift layer outside of the well region; a gate electrode extending along an upper surface of the well region and having a ring shape, wherein the gate electrode is disposed on the upper surface of the well region; a source electrode connected to the JFET region; and a drain electrode connected to the drain region.

According to example embodiments, a power semiconductor device may include: a substrate of a first conductivity type; a well region of a second conductivity type on the substrate; a drain region of the first conductivity type in the well region; a JFET region of the first conductivity type outside of the well region; a gate electrode on an upper surface of the well region; a source electrode connected to the JFET region; and a drain electrode connected to the drain region, and the upper surface of the well region may have a constant width and may surround an upper surface of the drain region, and the gate electrode may vertically overlap a portion of each of the well region, the drain region and the JFET region.

According to example embodiments, a power semiconductor device may include: a substrate including SiC of a first conductivity type; a drift layer of the first conductivity type on the substrate; a drain region of the first conductivity type on the drift layer; a well region of a second conductivity type surrounding the drain region and disposed on the drift layer; a JFET region of the first conductivity type surrounding the well region and disposed on the drift layer; a gate electrode on an upper surface of the well region; a source electrode connected to the JFET region; and a drain electrode connected to the drain region, wherein the JFET region may include impurities of the first conductivity type at a lower concentration than the drain region.

According to example embodiments, a method of manufacturing a power semiconductor device may include: obtaining a substrate including silicon carbide (SiC) of a first conductivity type; forming a Junction Field-Effect Transistor (JFET) region of the first conductivity type on the substrate; using a mask layer to form a well region of a second conductivity type; using the mask layer to form a drain region of the first conductivity type on the substrate such that the well region surrounds the drain region; forming a gate electrode on an upper surface of the well region; forming a source electrode connected to the JFET region; and forming a drain electrode connected to the drain region.

In some embodiments, a self-aligned drain region may be formed in a well region and a source electrode may be connected to a JFET region, thereby providing a power semiconductor device having improved electrical characteristics.

Advantages and effects of the present application are not limited to the foregoing content and may be more easily understood from the description of example embodiments of the present disclosure.

At least some of the above and other features of the invention are set out in the claims.

### BRIEF DESCRIPTION OF THE DRAWINGS

The above and other aspects, features, and advantages of the present disclosure will be more clearly understood from the following detailed description, taken in conjunction with the accompanying drawings, in which:
FIG. 1 is a schematic plan view of a power semiconductor device according to example embodiments;
FIG. 2 is a schematic cross-sectional view of a power semiconductor device according to example embodiments;
FIGS. 3A to 3C are plan views illustrating power semiconductor devices according to example embodiments;
FIGS. 4A and 4B are cross-sectional views illustrating power semiconductor devices according to example embodiments; and
FIGS. 5A to 5D are views illustrating a process sequence of a method of manufacturing a power semiconductor device according to example embodiments.

### DETAILED DESCRIPTION

Hereinafter, example embodiments of the present disclosure will be described with reference to the accompanying drawings. Hereinafter, it may be understood that expressions such as "on," "above," "upper," "below," "beneath," "lower," and "side," are merely indicated based on drawings, except that they are indicated by drawings and referred to separately.

Recently, power semiconductor devices have required high-speed switching operations. Accordingly, power semiconductor devices using silicon carbide (SiC), which is able to withstand higher voltages than silicon (Si), have been researched.

Described herein are power semiconductor devices having improved electrical characteristics, and in some embodiments, the power semiconductor devices include SiC.

According to some embodiments, forming the power semiconductor device may include forming a drain region through a self-alignment process in a well region so that a constant channel length for the power semiconductor device may be obtained. In conventional manufacturing of power semiconductor devices, multiple photolithographic steps with different masks were required. By using separate masks for forming different regions of the device, misalignment with each mask can occur. Using more than one mask can therefore introduce degradation of device performance resulting from a channel having non-uniform length. The inventors have appreciated that such misalignment can be avoided through a self-align process with a single mask for a well region and drain region. By forming a drain region through a self-align process for the well region, the drain region can be centered properly, and a device having a constant channel length can be provided. In instances of multiple, separate masks, the drain region can be formed off center causing the region surrounding the drain region to be not constant or not uniform.

As described herein, the power semiconductor device may be a Metal Oxide Semiconductor Field Effect Transistor (MOSFET) type with enhanced electrical characteristics.

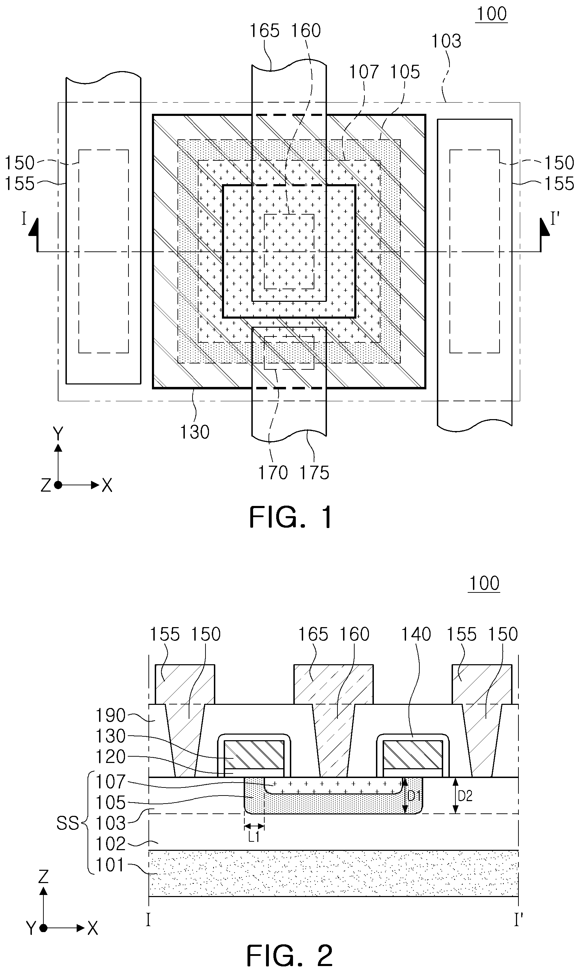

FIG. 1 is a schematic plan view of a power semiconductor device according to example embodiments.

FIG. 2 is a schematic cross-sectional view of a power semiconductor device according to example embodiments. FIG. 2 illustrates a cross-section along cutting line I-I' of FIG. 1.

Referring to FIGS. 1 and 2, a power semiconductor device 100 may include a substrate 101, a drift layer 102 on the substrate 101, a well region 105 on the drift layer 102, a drain region 107 in the well region 105, a JFET region 103 outside of the well region 105, a gate electrode 130 on an upper surface of the substrate 101, a gate insulating layer 120 between the gate electrode 130 and the substrate 101, a dielectric layer 140 covering the gate electrode 130, source electrodes 150 connected to the JFET region 103, a drain electrode 160 connected to the drain region 107, and a gate contact 170 connected to the gate electrode 130. The power semiconductor device 100 may further include source lines 155 extending from source electrodes 150, a drain line 165 extending from the drain electrode 160, and a gate line 175 extending from the gate contact 170, and an interlayer insulating layer 190 covering the dielectric layer 140.

A substrate structure SS may include a substrate 101, a drift layer 102, a JFET region 103, a well region 105, and a drain region 107.

The substrate 101 may have an upper surface extending in a first direction (an X-direction) and a second direction (a Y-direction) that is perpendicular to the first direction. The substrate 101 may include a semiconductor material, and for example, may include SiC. However, in some example embodiments, the substrate 101 may include a group IV semiconductor material such as Si or Ge, or a compound semiconductor material such as SiGe, GaN, GaAs, InAs, or InP.

The substrate 101 may be provided as a bulk wafer or an epitaxial layer. The substrate 101 may include impurities of first conductivity type, and may thus have a first conductivity type. In some example embodiments, the first conductivity type may be, for example, an N-type, and impurities of the first conductivity type may be, for example, N-type impurities, such as nitrogen (N) and/or phosphorus (P). In some example embodiments, the first conductivity type may be, for example, a P-type, and impurities of the first conductivity type may be, for example, P-type impurities, such as aluminum (Al).

The drift layer 102 may be disposed on the substrate 101. The drift layer 102 may include a semiconductor material, and may include, for example, SiC. The drift layer 102 may be an epitaxial layer grown on the substrate 101. The drift layer 102 may include the impurities of the first conductivity type, and may thus have the first conductivity type. A concentration of the impurities of the first conductivity type in the drift layer 102 may be lower than a concentration of the impurities of the first conductivity type in the substrate 101. In example embodiments, the impurities of the first conductivity type in the substrate 101 and the drift layer 102 may include the same or different elements.

The well region 105 may extend from an upper surface of the drift layer 102 by a predetermined depth and may be disposed on the drift layer 102. The well region 105 may include a semiconductor material, and may include, for example, SiC. The well region 105 may be a region having a second conductivity type and may include impurities of a second conductivity type. The second conductivity type may be different to the first conductivity type. The second conductivity type may be, for example, a P-type, and impurities of the second conductivity type may be, for example, P-type impurities such as aluminum (Al). In some example embodiments, the second conductivity type may be, for example, an N-type, and impurities of the second conductivity type may be, for example, N-type impurities, such as nitrogen (N) and/or phosphorus (P).

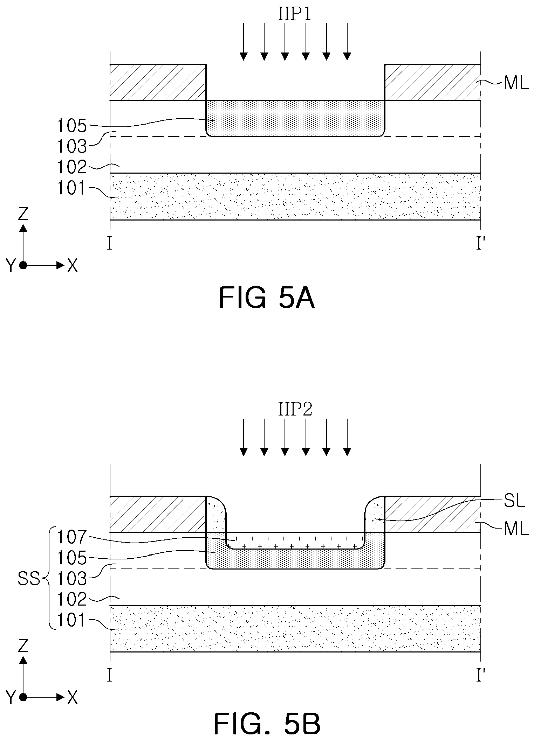

The drain region 107 may be disposed at a predetermined depth from upper surfaces of the well region 105. The drain region 107 may be spaced apart (e.g., may be disposed) inwardly from an edge or an outer line of the well region 105 by a first length L1 and may be disposed in the well region 105. The drain region 107 may be formed by self-alignment using the well region 105. This will be described in more detail with reference to FIG. 5B below. Accordingly, the upper surface of the well region 105 exposed through an upper surface of the substrate structure SS may have a width of the first length L1 in a horizontal direction uniformly around a perimeter of the drain region 107. A horizontal direction may be any direction that runs parallel to the plane (e.g. a horizontal plane) defined by the X-direction and the Y-direction. The width may be measured along a direction perpendicular to the perimeter of the drain region. The upper surface of the well region 105 may have a ring shape surrounding an entire upper surface of the drain region 107. In this specification, 'ring shape' refers to various hollow shapes such as a square ring, a circular ring, an oval ring, a polygonal ring, or the like. The upper surface of the well region 105, with the first length L1, may surround the drain region 107 entirely on a plane. The term "surround" may mean encircling or enclosing in all directions across at least one plane (e.g. a horizontal plane). The first length L1 (e.g. the distance between the drain region 107 and the drift region 105) may be the channel length. Accordingly, by providing a uniform first distance L1 around the drain region, a uniform channel length is provided. This improves the electrical characteristics of the power semiconductor device. For instance, a uniform channel length can provide more reliable and consistent switching, more predictable and lower on-resistance, and reduced power loss.

The drain region 107 may include a semiconductor material, for example, may include SiC. The drain region 107 may be a region having the first conductivity type, and may include the impurities of first conductivity type described above. A concentration of the impurities of the first conductivity type of the drain region 107 may be higher than a concentration of the impurities of the first conductivity type of the drift layer 102.

The JFET region 103 may be disposed on the drift layer 102 outside of the well region 105. The JFET region 103 may surround the well region 105 on a plane (e.g. a horizontal plane), as illustrated in FIG. 1. The JFET region 103 may include a semiconductor material, for example, SiC. The JFET region 103 may be a region having the first conductivity type and may include the impurities of the first conductivity type described above. A concentration of the impurities of the first conductivity type in the JFET region 103 may be higher than a concentration of the impurities of the first conductivity type in the drift layer 102 and may be lower than a concentration of the impurities of the first conductivity type in the drain region 107. The conductivity of the JFET region 103 may be changed depending on a voltage applied to the gate electrode 130, and accordingly, the resistance of a current path of the power semiconductor device 100 may be changed. Since the current control characteristics of the JFET region 103 are similar to those of a Junction Field-Effect Transistor (JFET), the JFET region 103 may be referred to as a JFET region. However, depending on the description, at least a portion of the JFET region 103 may be referred to as a current spreading layer.

In the present example embodiments, a second depth D2 from the upper surface of the substrate structure SS to a lower surface of the JFET region 103 may be substantially the same as a first depth D1 from the upper surface of the substrate structure SS to a lower surface of the well region 105, but the present disclosure is not limited thereto. In some example embodiments, the second depth D2 may be smaller than the first depth D1. In some example embodiments, in the JFET region 103, a concentration of the impurities of the first conductivity type may gradually decrease toward the drift layer 102.

The gate electrodes 130 may be disposed on the substrate structure SS and may extend along the upper surface of the well region 105 included in the upper surface of the substrate structure SS. The gate electrodes 130 may have a shape corresponding to a shape of the upper surface of the well region 105 on a plane, and may have, for example, a ring shape, e.g., a square ring shape. However, in some example embodiments, the gate electrodes 130 may have a shape corresponding to a portion of the ring shape, or may have a circular ring shape, an elliptical ring shape, or a polygonal ring shape.

The gate electrodes 130 may be disposed on the upper surface of the well region 105, a portion of the upper surface of the drain region 107, and a portion of an upper surface of the JFET region 103. The gate electrodes 130 may overlap a portion of the well region 105, a portion of the drain region 107, and a portion of the JFET region 103, in a vertical direction, for example, in a Z-direction. In the present example embodiments, the gate electrodes 130 may cover the entire upper surface of the well region 105, and may overlap the entire upper surface (e.g., an entirety) thereof, in the vertical direction, for example, in the Z-direction. The gate electrode 130 may be spaced apart from the well region 105, the drain region 107, and the JFET region 103, by the gate insulating layer 120.

The gate electrode 130 may include a conductive material, and may include, for example, a semiconductor material such as doped polycrystalline silicon or a metallic material. The metallic material may be, for example, at least one of titanium nitride (TiN), titanium (Ti), titanium carbide (TiC), tantalum nitride (TaN), tungsten nitride (WN), aluminum (Al), tungsten (W), or molybdenum (Mo). According to example embodiments, the gate electrode 130 may be formed of two or more multilayers.

The gate insulating layer 120 may be disposed on a lower surface of the gate electrode 130. The gate insulating layer 120 may be disposed between the well region 105 and the gate electrode 130, between the drain region 107 and the gate electrode 130, and between the JFET region 103 and the gate electrode 130.

The gate insulating layer 120 may include an oxide, a nitride, or a high-κ material. A high-κ material may refer to a dielectric material having a higher dielectric constant than that of silicon oxide (SiO₂). The high-κ material may be, for example, any one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), or praseodymium oxide (Pr₂O₃). In some embodiments, the gate insulating layer 120 may be formed of two or more multilayers.

The dielectric layer 140 may cover the gate electrode 130, and may be disposed to expose at least portions of each of the drain region 107 and the JFET region 103. The dielectric layer 140 may cover a side surface of the gate electrode 130 and a side surface of the gate insulating layer 120. The dielectric layer 140 may include an insulating material, and may include at least one of silicon oxide, silicon nitride, or silicon oxynitride. In some example embodiments, the dielectric layer 140 may include a high-κ material.

The interlayer insulating layer 190 may cover the dielectric layer 140 and the substrate structure SS. The interlayer insulating layer 190 may include an insulating material and may include at least one of silicon oxide, silicon nitride, or silicon oxynitride. In some example embodiments, the interlayer insulating layer 190 may include a low-κ material. A low-κ material may refer to a dielectric material having a lower dielectric constant than that of silicon oxide (SiO₂).

The source electrodes 150 may penetrate through the interlayer insulating layer 190 on the JFET region 103 and may be connected to the JFET region 103. The source electrodes 150 may apply an electrical signal to the JFET region 103. The source electrodes 150 may be disposed on each of both sides of the gate electrode 130 in one direction, for example, the X-direction. The source electrodes 150 may be connected to source lines 155 extending in one direction, for example, the Y-direction. The source electrodes 150 and the source lines 155 may be formed integrally, but in some example embodiments, the source electrodes 150 and the source lines 155 may be formed of layers of different materials.

The drain electrode 160 may be connected to the drain region 107 by penetrating through the interlayer insulating layer 190 in a region surrounded by the gate electrode 130 on a plane. The drain electrode 160 may apply an electrical signal to the drain region 107. In the present example embodiments, the drain electrode 160 may be completely surrounded by the gate electrode 130 on a plane or may be at least partially surrounded by the gate electrode 130. The gate electrode 130 may be spaced apart from the drain electrode 160 horizontally. The drain electrode 160 may be spaced apart from the source electrodes 150 by the gate electrode 130 on the plane (e.g. the horizontal plane) (e.g., spaced apart with the gate electrode 130 interposed therebetween). The drain electrode 160 may be connected to a central region including a center of the drain region 107. The drain electrode 160 may be connected to a drain line 165 extending in one direction (e.g. one horizontal direction), for example, the Y-direction. The drain electrode 160 and the drain line 165 may be formed integrally but may be formed of layers of different materials in some example embodiments.

The gate contact 170 may penetrate through the interlayer insulating layer 190 and the dielectric layer 140 on the gate electrode 130 and may be electrically connected to the gate electrode 130. As illustrated in FIG. 1, the gate contact 170 may be connected to a region of the gate electrode 130 extending in the X-direction (e.g., a first direction). As illustrated in FIG. 1, the gate contact 170 may be disposed on at least one side of the drain electrode 160 in the Y-direction (e.g., a second direction that is perpendicular to the first direction). The gate contact 170 may be disposed in a region overlapping the drain electrode 160 in the Y-direction and/or on a straight line in the Y-direction with the drain electrode 160, but the present disclosure is not limited thereto. The gate contact 170 may be connected to a gate line 175 extending in one direction, for example, the Y-direction. The gate contact 170 and the gate line 175 may be formed integrally, but in some example embodiments, the gate contact 170 and the gate line 175 may be formed of layers of different materials.

The source electrodes 150, the source lines 155, the drain electrode 160, the drain line 165, the gate contact 170, and the gate line 175 may include a metallic material, for example, at least one of nickel (Ni), aluminum (Al), titanium (Ti), silver (Ag), vanadium (V), tungsten (W), cobalt (Co), molybdenum (Mo), copper (Cu), or ruthenium (Ru). At least one of the source electrodes 150, the drain electrode 160, or the gate contact 170 may include a metal-semiconductor compound layer disposed on an interface in contact with the JFET region 103, the drain region 107, and the gate electrode 130, respectively. The metal-semiconductor compound layer may include a metal element and a semiconductor element, and may include, for example, at least one of TiSi, CoSi, MoSi, LaSi, NiSi, TaSi, or WSi.

The power semiconductor device 100 may include a drain region 107 formed by self-alignment to the well region 105, so that a length (e.g., a width in a horizontal direction) of the well region 105 exposed through the upper surface of the substrate structure SS may be constant, and thus a channel length may be constant. In some embodiments, the channel may have an annular shape based at least in part on the shape of the drain region 107 or may include portions (e.g., two portions) of such an annular shape. The channel may be established between the drain region 107 and source. Additionally, since the source electrodes 150 and the drain electrodes 160 have a horizontally disposed lateral Metal Oxide Semiconductor Field Effect Transistor (MOSFET) form, the electrical characteristics may be enhanced as compared to the vertical MOSFET structure because the source electrodes 150 and the drain electrodes 160 are not subject to resistance due to the drift layer 102.

As described above, the power semiconductor device 100 is described as an example of a MOSFET type, but the arrangement of the well region 105, the drain region 107, and the source electrodes 150 of example embodiments may also be applied to an Insulated Gate Bipolar Transistor (IGBT) device, or the like. For example, when the power semiconductor device is an IGBT, the substrate 101 may have the second conductivity type.

In the description of the example embodiments below, any description overlapping the description described above with reference to FIGS. 1 and 2 will be omitted.

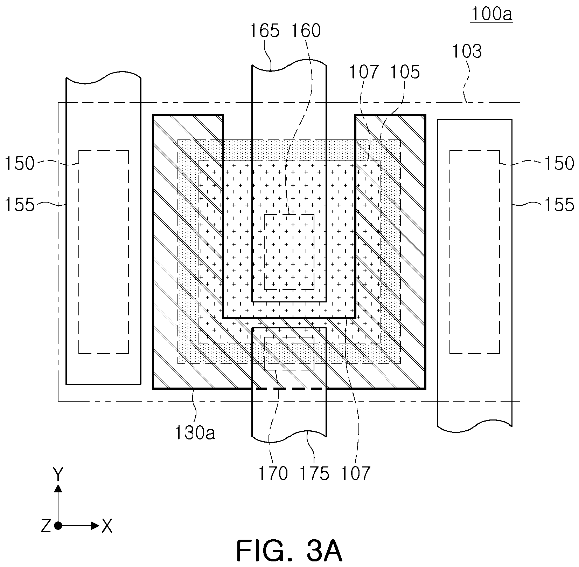

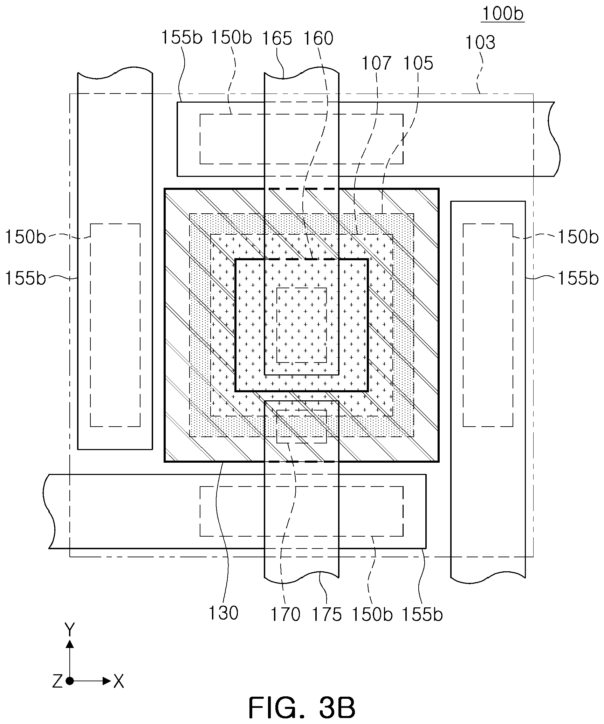

FIGS. 3A to 3C are plan views illustrating power semiconductor devices according to example embodiments. FIGS. 3A and 3B illustrate regions corresponding to FIG. 1.

Referring to FIG. 3A, in a power semiconductor device 100a, a gate electrode 130a may be disposed to surround a portion of the drain region 107. The gate electrode 130a may overlap a portion of the upper surface of the well region 105 in the Z-direction. As compared to the gate electrode 130 of FIG. 1, the gate electrode 130a may have a form in which one or more regions not disposed between the source electrode 150 and the drain electrode 160 are omitted. For example, the gate electrode 130a may have a form in which one or more regions extending in the X-direction, a direction in which the source electrodes 150 and the drain electrode 160 are arranged, are omitted. Accordingly, the gate electrode 130a may have a shape of a portion of a ring, an open ring shape, a cup shape, a U-shape or a hook shape.

Referring to FIG. 3B, in a power semiconductor device 100b, source electrodes 150b and source lines 155b may be further disposed on both sides of the drain region 107 in the Y-direction. Accordingly, the source electrodes 150b may be disposed on both sides of the gate electrode 130 in the X-direction and both sides of the gate electrode 130 in the Y-direction, respectively. The source lines 155b may be disposed to be connected to the source electrodes 150b, respectively. In some example embodiments, at least some portions of the source lines 155b may be connected to each other. In the present example embodiments, the drain line 165 and the gate line 175 may be disposed on one or more different levels from the source lines 155b.

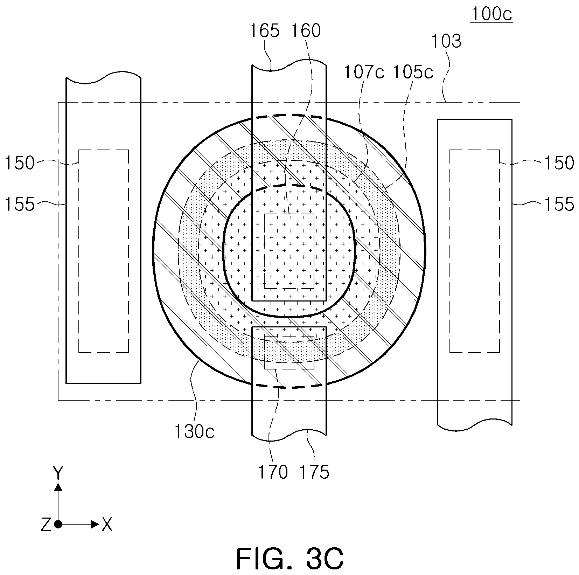

Referring to FIG. 3C, in a power semiconductor device 100c, an upper surface of a well region 105c and a gate electrode 130c may have a circular ring shape. Accordingly, a drain region 107c disposed inside the well region 105c may have a circular shape. In example embodiments, in this manner, a shape of an upper surface of the well region 105c and a shape of the gate electrode 130c according thereto may be variously changed.

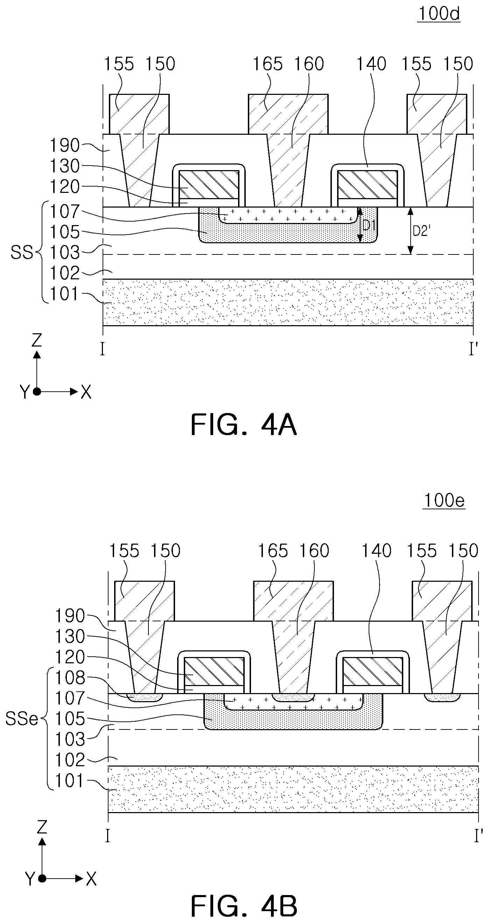

FIGS. 4A and 4B are cross-sectional views illustrating power semiconductor devices according to example embodiments.

Referring to FIG. 4A, in a power semiconductor device 100d, a second depth D2' from the upper surface of the substrate structure SS to a lower end of the JFET region 103 may be greater than the first depth D1 from the upper surface of the substrate structure SS to a lower end of the well region 105. Accordingly, the JFET region 103 may cover the lower surface of the well region 105 and may extend horizontally on the drift layer 102. In some example embodiments, in the JFET region 103, an upper region thereof and a lower region on the lower surface of the well region 105 may have different impurity concentrations.

Referring to FIG. 4B, in a power semiconductor device 100e, a substrate structure SSe may further include contact impurity regions 108. The contact impurity regions 108 may be disposed between the source electrode 150 and the JFET region 103 and between the drain electrode 160 and the drain region 107. The contact impurity regions 108 may be disposed on lower surfaces of the source electrodes 150 and the drain electrode 160 in the substrate structure SSe. The contact impurity regions 108 may include impurities of the same conductivity type as the JFET region 103 and the drain region 107, for example, the impurities of the first conductivity type. The contact impurity regions 108 in contact with the source electrodes 150 may include the impurities of the first conductivity type at a higher concentration than that of the JFET region 103, and the contact impurity region 108 in contact with the drain electrode 160 may include the impurities of the first conductivity type at a higher concentration than the drain region 107. The impurity concentrations of the contact impurity regions 108 in contact with the source electrodes 150 and the contact impurity region 108 in contact with the drain electrode 160 may be identical to or different from each other. The contact resistance of the source electrodes 150 and the drain electrode 160 may be reduced by the contact impurity regions 108.

FIGS. 5A to 5D are views illustrating a process sequence of a method of manufacturing a power semiconductor device according to example embodiments. FIGS. 5A to 5D illustrate example embodiments of a manufacturing method of manufacturing the power semiconductor device of FIGS. 1 and 2 and illustrate a region corresponding to FIG. 2.

Referring to FIG. 5A, a drift layer 102 and a JFET region 103 may be formed on a substrate 101, and a well region 105 may be formed by performing a first ion implantation process IIP1. In some embodiments, a first region being formed on one or more other regions may include the first region being formed directly on the one or more other regions or may include the first region being formed directly on an intervening layer such that the intervening layer separates the first region from the one or more other regions.

The substrate 101 may be provided as, for example, a SiC wafer. The drift layer 102 may be formed by epitaxial growth from the substrate 101. The drift layer 102 may be formed to include the first conductivity type impurities. The JFET region 103 may be formed by performing an ion implantation process on an upper region of the drift layer 102 after forming the drift layer 102 to additionally implant the impurities of the first conductivity type. Alternatively, the JFET region 103 may be formed on the drift layer 102 and may include the impurities of the first conductivity type at a higher concentration than that of the drift layer 102 by in-situ doping.

Next, a mask layer ML may be formed on the JFET region 103 and a first ion implantation process IIP1 may be performed to form a well region 105. The mask layer ML may be a hard mask layer. For example, the mask layer ML may include silicon oxide. The impurities of the second conductivity type may be implanted by the first ion implantation process IIP1, so that a well region 105 extending from the upper surface of the JFET region 103 to a predetermined depth may be formed. A depth of the well region 105 may be identical to or different from a depth of the JFET region 103.

Referring to FIG. 5B, spacers SL may be formed on side surfaces of the mask layer ML, and a second ion implantation process IIP2 may be performed to form a drain region 107. Since a mask is already in place for forming well region 105, by reusing the same mask for forming drain region 107, the possibility of mask misalignment for multiple fabrication processes is reduced.

The spacers SL may be formed by depositing a material on the mask layer ML and the well region 105 to form a preliminary spacer layer, and then partially removing the preliminary spacer layer on a horizontal plane. The spacers SL may include, for example, silicon oxide, silicon nitride, or silicon oxynitride. The preliminary spacer layer may be deposited to have a uniform thickness, and thus, the spacers SL may have a substantially constant width and may extend to cover an edge of the well region 105.

Next, the second ion implantation process IIP2 may be performed on the well region 105 exposed by the mask layer ML and spacers SL to form a drain region 107. The impurities of the first conductivity type may be implanted by the second ion implantation process IIP2. After the second ion implantation process IIP2, an annealing process may be performed at a high temperature, for example, about 1600° C to about 1800° C (e.g. from 1600° C to 1800° C), but the present disclosure is not limited thereto. Accordingly, the substrate structure SS including the substrate 101, the drift layer 102, the JFET region 103, the well region 105, and the drain region 107 may be formed. In this operation, an edge region of the well region 105 covered with the spacers SL and defined by the drain region 107 may correspond to a channel region of the power semiconductor device. Accordingly, the power semiconductor device may be formed to have a constant channel length by this process. The channel length may be defined by the width of the spacers SL on the sidewalls of the mask layer ML (e.g. in a direction perpendicular to the sidewalls). After the drain region is formed 107 the mask layer ML and spacers SL may be removed.

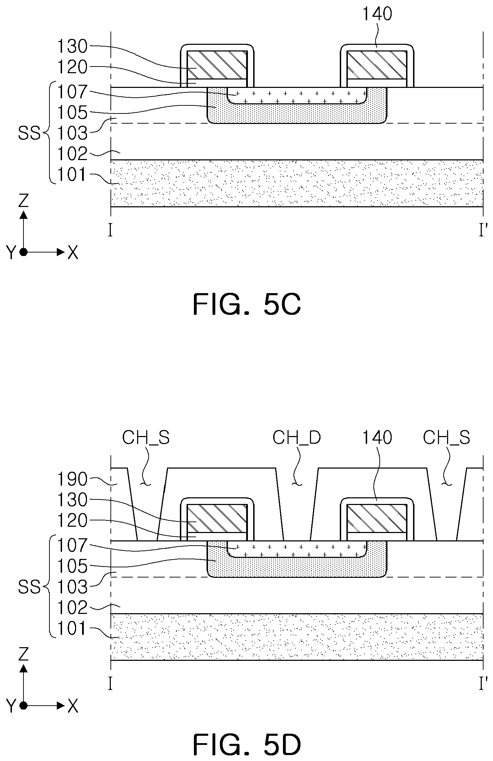

Referring to FIG. 5C, a gate insulating layer 120, a gate electrode 130, and a dielectric layer 140 may be formed.

The gate insulating layer 120 and the gate electrode 130 may be formed by sequentially forming an insulating layer and a conductive layer on upper surfaces of the JFET region 103, the well region 105, and the drain region 107 and patterning the insulating layer and the conductive layer. The insulating layer and the conductive layer may be patterned together (e.g. simultaneously). The gate insulating layer 120 may be formed by a deposition process or an oxidation process, for example, a thermal oxidation process. The gate electrode 130 may be formed by, for example, depositing doped polycrystalline silicon. In some example embodiments, the gate electrode 130 may also be formed of a metallic material.

The dielectric layer 140 may be deposited on an entire upper surface of the structure being manufactured and may then be partially removed and formed to expose a portion of each of the JFET region 103 and the drain region 107 in an etching process. The dielectric layer 140 may be formed to cover an upper surface and a side surface of the gate electrode 130, to cover a side surface of the gate insulating layer 120, and to contact a portion of the upper surface of the JFET region 103, and a portion of the upper surface of the drain region 107.

Referring to FIG. 5D, an interlayer insulating layer 190 may be formed, and first and second contact holes CH_S and CH_D penetrating through the interlayer insulating layer 190 may be formed.

The interlayer insulating layer 190 may be formed by depositing an insulating material on the substrate structure SS and the dielectric layer 140. The first and second contact holes CH_S and CH_D may be formed by removing the interlayer insulating layer 190 in regions corresponding to the source electrodes 150 and the drain electrode 160 of FIG. 2. The JFET region 103 may be exposed through the first contact holes CH_S, and the drain region 107 may be exposed through the second contact hole CH_D.

Next, referring to FIG. 2 and FIG. 5D together, a conductive material may be deposited on the first and second contact holes CH_S and CH_D to form source electrodes 150 and drain electrodes 160, and source lines 155 and drain lines 165 may be formed. The gate contact 170 of FIG. 1 may be formed together with the source electrodes 150 and the drain electrode 160, and the gate line 175 of FIG. 1 may be formed together with the source lines 155 and drain lines 165, but the present disclosure is not limited thereto. In this manner, the power semiconductor device 100 of FIG. 1 and FIG. 2 may be manufactured.

A method of manufacturing a power semiconductor device according to techniques described herein may include: obtaining a substrate including silicon carbide (SiC) of a first conductivity type; forming a Junction Field-Effect Transistor (JFET) region of the first conductivity type on the substrate; using a mask layer to form a well region of a second conductivity type; using the mask layer to form a drain region of the first conductivity type on the substrate such that the well region surrounds the drain region; forming a gate electrode on an upper surface of the well region; forming a source electrode connected to the JFET region; and forming a drain electrode connected to the drain region.

Using the mask layer to form a drain region may comprise: forming one or more spacers on the mask layer to narrow one or more openings in the mask layer by a consistent length; and forming the drain region using the mask layer and the one or more spacers. The consistent length, may be a length each sidewall is moved inwards (e.g. into the corresponding opening) by the one or more spacers.

Forming one or more spacers may comprise: forming a preliminary spacer layer over the mask layer, wherein the preliminary spacer layer comprises one or more sidewall portions covering one or more sidewalls of the one or more openings to a uniform thickness; and partially removing the preliminary spacer layer, leaving the one or more sidewall portions to form the one or more spacers.

Embodiments are set out in the following Clauses:
Clause 1. A power semiconductor device, comprising:
   a substrate of a first conductivity type;
   a well region of a second conductivity type on the substrate;
   a drain region of the first conductivity type in the well region;
   a Junction Field-Effect Transistor (JFET) region of the first conductivity type outside of the well region;
   a gate electrode on an upper surface of the well region;
   a source electrode connected to the JFET region; and
   a drain electrode connected to the drain region,
   wherein the upper surface of the well region has a constant width and surrounds an upper surface of the drain region, and
   wherein the gate electrode vertically overlaps a portion of each of the well region, the drain region, and the JFET region.
Clause 2. The power semiconductor device of Clause 1,
   wherein the gate electrode covers an entirety of the upper surface of the well region.
Clause 3. The power semiconductor device of Clause 1 or Clause 2,
   wherein the well region has a ring shape surrounding the drain region on a plane.
Clause 4. The power semiconductor device of Clause 3,
   wherein the gate electrode has a ring shape corresponding to the well region on a plane.
Clause 5. The power semiconductor device of Clause 4,
   wherein the source electrode and the drain electrode are spaced apart from each other with the gate electrode interposed therebetween.
Clause 6. The power semiconductor device of any preceding Clause,
   wherein the JFET region surrounds the well region on a plane.
Clause 7. The power semiconductor device of any preceding Clause, further comprising:
   contact impurity regions between the source electrode and the JFET region and between the drain electrode and the drain region.
Clause 8. A power semiconductor device, comprising:
   a substrate including SiC of a first conductivity type;
   a drift layer of the first conductivity type on the substrate;
   a drain region of the first conductivity type on the drift layer;
   a well region of a second conductivity type surrounding the drain region and disposed on the drift layer;
   a JFET region of the first conductivity type surrounding the well region and disposed on the drift layer;
   a gate electrode on an upper surface of the well region;
   a source electrode connected to the JFET region; and
   a drain electrode connected to the drain region,
   wherein the JFET region includes impurities of the first conductivity type at a lower concentration than the drain region.
Clause 9. The power semiconductor device of Clause 8,
   wherein the gate electrode vertically overlaps a portion of each of the well region, the drain region, and the JFET region.
Clause 10. The power semiconductor device of Clause 8 or Clause 9, wherein the power semiconductor device includes a lateral Metal Oxide Semiconductor Field Effect Transistor (MOSFET) device.

The present disclosure is not limited to the above-described embodiments and the accompanying drawings but is defined by the appended claims. Therefore, those of ordinary skill in the art may make various replacements, modifications, or changes, and combinations of example embodiments without departing from the scope of the present disclosure defined by the appended claims, and these replacements, modifications, or changes should be construed as being included in the scope of the present disclosure.

## Claims

1. A power semiconductor device, comprising:
a substrate including silicon carbide of a first conductivity type;
a drift layer of the first conductivity type on the substrate;
a well region of a second conductivity type on the drift layer;
a drain region of the first conductivity type spaced apart inwardly from an edge of the well region by a first length and disposed in the well region;
a Junction Field-Effect Transistor, hereinafter referred to as JFET, region of the first conductivity type on the drift layer outside of the well region;
a gate electrode extending along an upper surface of the well region and at least partially surrounding the drain region, wherein the gate electrode is disposed on the upper surface of the well region;
a source electrode connected to the JFET region; and
a drain electrode connected to the drain region,
wherein a channel region of the power semiconductor device has a constant channel length.

2. The power semiconductor device of claim 1,
wherein the gate electrode is spaced apart from the drain electrode horizontally and surrounds the drain electrode.

3. The power semiconductor device of claim 1 or claim 2,
wherein the gate electrode vertically overlaps an entirety of the upper surface of the well region.

4. The power semiconductor device of claim 1 or claim 2,
wherein the gate electrode vertically overlaps a portion of the upper surface of the well region.

5. The power semiconductor device of any preceding claim,
wherein the upper surface of the well region, with the first length, surrounds the drain region entirely on a plane.

6. The power semiconductor device of any preceding claim,
wherein an impurity concentration of the JFET region is higher than an impurity concentration of the drift layer.

7. The power semiconductor device of claim 6,
wherein the impurity concentration of the JFET region is lower than an impurity concentration of the drain region.

8. The power semiconductor device of any preceding claim, wherein:
the source electrode is one of first and second source electrodes, and
the first and second source electrodes are respectively on both sides of the gate electrode in a first direction.

9. The power semiconductor device of claim 8, further including a gate contact connected to the gate electrode,
wherein the gate contact is on at least one side of the drain electrode in a second direction that is perpendicular to the first direction.

10. The power semiconductor device of any preceding claim,
wherein the first conductivity type is an N-type and the second conductivity type is a P-type.

11. A method of manufacturing a power semiconductor device, the method comprising:
obtaining a substrate including silicon carbide (SiC) of a first conductivity type;
forming a Junction Field-Effect Transistor (JFET) region of the first conductivity type on the substrate;
using a mask layer to form a well region of a second conductivity type;
using the mask layer to form a drain region of the first conductivity type on the substrate such that the well region surrounds the drain region;
forming a gate electrode on an upper surface of the well region;
forming a source electrode connected to the JFET region; and
forming a drain electrode connected to the drain region.

12. The method of claim 11,
wherein the gate electrode vertically overlaps a portion of each of the well region, the drain region, and the JFET region, and
wherein the JFET region includes impurities of the first conductivity type at a lower concentration than the drain region.

13. The method of claim 11 or claim 12, wherein the power semiconductor device includes a lateral Metal Oxide Semiconductor Field Effect Transistor (MOSFET) device.

14. The method of any of claims 11-13 wherein using the mask layer to form a drain region comprises:
forming one or more spacers on the mask layer to narrow one or more openings in the mask layer by a consistent length; and
forming the drain region using the mask layer and the one or more spacers.

15. The method of claim 14 wherein forming one or more spacers comprises:
forming a preliminary spacer layer over the mask layer, wherein the preliminary spacer layer comprises one or more sidewall portions covering one or more sidewalls of the one or more openings to a uniform thickness; and
partially removing the preliminary spacer layer, leaving the one or more sidewall portions to form the one or more spacers.
